# EUROPEAN PATENT APPLICATION

(11) **EP 1 454 879 A1**
(43) Date of publication of application: **08.09.2004**
(21) Application number: 02788766.0
(22) Date of filing: 10.12.2002
(51) Int. Cl.: C01B 13/14, C01B 13/32, C01B 33/12, H01L 29/78, H01L 21/316

(54) **PROCESS FOR PRODUCING THIN OXIDE FILM AND PRODUCTION APPARATUS**

(30) Priority: 11.12.2001 JP 2001377102
(71) Applicant: National Institute of Advanced Industrial Science and Technology, Tokyo 100-0013 (JP)
(72) Inventor: YASUDA, T., Nat. Inst. of Advanced Ind. Science &, Tsukuba-shi, Ibaraki 305-8562 (JP); NISHIZAWA, M., Nat. Inst. of Advanced Ind. Science, Tsukuba-shi, Ibaraki 305-8562 (JP); YAMASAKI, S., Nat. Inst. of Advanced Ind. Science, Tsukuba-shi, Ibaraki 305-8562 (JP)
(74) Representative: Smith, Norman Ian
(86) International application number: PCT/JP2002/012913
(87) International publication number: WO 2003/050038

(57) **Abstract**

In a method of manufacturing oxide thin film by adsorbing or depositing oxide forming starting material on a substrate followed by oxide formation, by using water in a liquid state to manufacture the oxide thin film, the advantages of the ALD method are utilized while resolving the tendency to leave impurities in the oxide film produced that is a drawback thereof, so that oxide thin film can be obtained having a reduced concentration of impurities.

## Description

### Technical Field:

The present invention relates to a method and apparatus for manufacturing oxide thin film that can be used as an insulator, dielectric, semiconductor or magnetic material in various electronic devices.

### Background Art:

Oxides have been used as insulators and dielectrics in the manufacture of various electronic devices. Among them, SiO₂ is used as MOS transistor gate insulation film, element isolation film and interlayer insulation film. Recently, along with the progress in the shrinkage of integrated circuits, considerable research is being conducted aimed at replacing the SiO₂ used for gate insulation films with an oxide material having a higher dielectric constant.

Also in oxides, there are substances, such as ZnO, that are being studied for semiconductor applications and substances, such as perovskite type oxides, having singular properties that are attracting attention as superconductors and magnetic materials.

Thus, oxides are becoming increasingly important as materials for future electronic devices.

Processes for fabricating oxide thin film for electronic devices include the vacuum deposition method, the sputtering method, the chemical-vapor deposition (CVD) method, the laser deposition method, the oxidation method and the sol-gel method. Of these, the improved-CVD method called the atomic layer deposition (ALD) method is recently attracting attention as a method suited to the formation of the aforementioned gate insulation layers having a high dielectric constant.

The ALD method principle is more or less the following (S. M. George, A. E. Ott and J. W. Klaus, Journal of Physical Chemistry, vol. 100, pp. 13121-13131, 1996).

When growing a metal oxide, for example, first, a material that includes the metal (halogen compound, organic metal and the like) supplied from a vapor phase is adsorbed on a substrate surface. Next, O₂ gas or H₂O vapor is supplied, forming the adsorbed material into an oxide. An oxide thin film can be grown through repetition of these processes.

The advantages of this method are that, because the thickness of the film is determined by the number of times the processes are repeated, the thickness can be controlled with the precision of the atomic layers, film with no thickness distribution can be grown on a substrate having a large area, and uniform growth is possible on a substrate that is stepped or grooved.

Drawbacks that can be cited include slow growth rate and that it tends to leave in the produced film impurities, such as halogen and carbon, originating in the starting material. The latter is a particularly major problem with respect to the formation of gate insulation films that are required to have as few defects and impurities as possible. This is one reason that is preventing the ALD method from being practically utilized.

In order to utilize the above advantages of the ALD method while resolving the problem that is a drawback thereof, that it tends to leave impurities in the produced oxide thin film, an object of the present invention is to provide a manufacturing method that is well-suited for obtaining insulating film that is thin and has a high dielectric constant that is useful as gate insulation films in integrated circuits of MOS transistors.

### Disclosure of the Invention:

The present invention provides a method of manufacturing oxide thin film by a process of adsorbing or depositing oxide forming starting material on a substrate followed by an oxide forming reaction process, which method is characterized in that the oxide forming reaction process is performed using water in a liquid state.

In the method, the process of adsorbing or depositing oxide forming starting material on a substrate and oxide forming reaction process are performed one time or a plurality of times.

In the method, the oxide forming starting material comprises two or more different types of oxide subject elements.

In the method, the process of adsorbing or depositing oxide forming starting material on a substrate includes simultaneous use of two or more different types of oxide subject elements, or differentiating the starting material after performing the adsorbing or depositing process and oxide forming reaction process one time or a plurality of times.

The present invention also provides an apparatus that implements the above method of manufacturing an oxide thin film, which apparatus is equipped with separate chambers to perform, respectively, the process of adsorbing or depositing oxide forming starting material on a substrate and the oxide forming reaction process utilizing contact with water in a liquid state.

The invention also provides an apparatus that implements the above method of manufacturing an oxide thin film, which apparatus is equipped with a single chamber to sequentially perform the process of adsorbing or depositing oxide forming starting material on a substrate and the oxide forming reaction process utilizing contact with water in a liquid state.

While the method of the present invention, in which oxide thin film is manufactured by a process of adsorbing or depositing oxide forming starting material on a substrate followed by an oxide forming reaction process, is characterized in that the oxide forming reaction process is performed using water in a liquid state, the following are two possible reasons why impurities are reduced by using water in a liquid state.

First, compared to vapor, since liquid has more molecules per unit volume, the frequency at which the starting material adsorbed/deposited on the surface collides with the water molecules is incommensurably higher, so there is sufficient progress of the oxide forming reaction.

Second, when the reaction products are hydrophilic, the hydration effect possessed by the liquid water has the effect of promoting the reaction.

As described above, because the oxide forming reaction proceeds effectively, the impurity concentration in the oxide thin film that is produced is considerably reduced.

### Brief Description of Drawings:

Figure 1(a) is a schematic diagram showing an example configuration of an oxide thin film manufacturing apparatus according to the present invention that has two chambers.
Figure 1(b) is a schematic diagram showing another example configuration of an oxide thin film manufacturing apparatus according to the present invention that has two chambers.
Figure 2 is a schematic diagram showing an example configuration of an oxide thin film manufacturing apparatus according to the present invention that has a single chamber.
Figure 3 is a diagram showing the Si LVV Auger electron spectrogram of SiO₂ thin film produced by an embodiment.
Figure 4 is a diagram showing the Si LVV Auger electron spectrogram of SiCl₄ thin film produced by an embodiment.

### Best Mode for Carrying out the Invention:

As a result of assiduous research carried out by the present inventors to resolve the tendency to leave impurities in the produced oxide thin film that is a drawback of the ALD method, it was found that in oxide thin film grown by the ALD method the concentration of impurities included therein originating in the starting material is a product of an incomplete oxide forming reaction, and that in the oxide forming process the reaction can be effectively advanced and the impurity concentration dramatically reduced by contacting oxides adsorbed or deposited on the substrate surface with liquid-state water, not vapor, to form the oxide thin film. These findings led to the perfection of the present invention.

That is, the method of the present invention of manufacturing oxide thin film by adsorbing or depositing oxide forming starting material on a substrate followed by an oxide forming reaction is characterized in that the oxide forming reaction is performed using water in a liquid state.

There is no particular limitation on the type of substrate material used in this invention, so long as it is stable at temperatures at which the oxide forming starting material is adsorbed or deposited on the substrate and is also stable when contacted with water in the liquid state. Examples include Si, SiO₂, Si₃N₄, Al₂O₃ and SiC.

A silicon wafer is used when forming gate insulation film for MOS transistors. Oxidation, nitriding, hydrogen termination or hydroxyl group termination of the surface thereof makes it possible to speedily and uniformly distribute the oxide forming material on the substrate surface. Methods of forming the oxidation, nitriding, hydrogen termination or hydroxyl group termination include, for example, a method of heating in O₂, O₃, H₂O, N₂, NH₃, NO, and NO₂ and using plasma processing to oxidize or nitride the substrate surface, a method of etching in a solution containing fluorine, and a method of oxidation processing in an acid or alkaline solution.

In the present invention, oxides that can be used to form a thin film include compounds expressed as MₓO_{y} (in which M is an element other than oxygen and x and y represent a positive integer), such as for example SiO₂, ZnO, Al₂O₃, TiO₂, HfO₂, ZrO₂, Y₂O₃, La₂O₃ and Ta₂O₅. However, the elements to be subjected to oxidation can be in the form of a plurality of complex oxides.

In the present invention, oxide forming starting material refers to starting material that can produce oxides on a solid when oxidized or hydrolyzed. Any metal, half-metal, non-metal or compound containing these that satisfies this condition can be used. Specific examples include elements, such as Al, Si, Ti, Zn, Zr, Hf, Y, La and Ta; also these-elements-containing halogenides (chloride, bromide and so forth); compounds modified with organic group, such as the alkyl group and the alkoxyl group; and carbonyl compounds. In cases where these are used, in the subsequent oxide forming process oxide thin film can be obtained by contacting these compounds adsorbed or deposited on the substrate with water in the liquid state. However, vapor deposition, electrodeposition and the like can be used to adsorb or deposit the elements directly onto the substrate surface for oxidation.

In the process of adsorbing or depositing the oxide forming starting material, the substrate is placed in a chamber and maintained at a suitable temperature for adsorbing or depositing the oxide forming starting material.

When a vapor phase, for example, is used to supply the starting material to the substrate surface, the starting material is used in a gaseous state, or the starting material is vaporized inside the chamber, or the starting material is vaporized in a starting material vessel that is separate from the reactor and is introduced into the chamber using a carrier gas if necessary. When the starting material is supplied to the substrate from a liquid phase, the starting material is dissolved in a suitable solvent, the solution is coated onto the substrate surface and the solvent is then evaporated.

The oxide forming process is performed in the same chamber as the process of adsorbing or depositing the oxide forming starting material on the substrate, or in cases in which reacting the starting material and water elsewhere than on the substrate surface would give rise to an undesirable outcome, the process of adsorbing or depositing on the substrate and the oxide forming process are performed in separate chambers. A substrate temperature is used that is lower than the boiling point of water and higher than the freezing point.

In the oxide forming process, there are two methods of contacting liquid water with the starting material adsorbed or deposited on the substrate surface, which are to contact the substrate surface with water in a liquid state introduced into the chamber via a nozzle or shower, or to introduce water vapor into the chamber and precipitate it into a liquid state for contacting with the substrate surface. In the latter case, the water vapor is precipitated by cooling the substrate or vessel wall to or below the dew-point temperature of the water vapor, or by cooling using adiabatic expansion of a gas containing the water vapor.

The oxide forming process is concluded when the contacted liquid water has been evaporated and the substrate surface has been dried. When the water evaporation is slow, spinning the substrate to use centrifugal force to remove the water, or spraying it with inert gas and using vacuum suction are effective. It is also possible to control the surface chemical structure at the conclusion of the oxide forming process by controlling the pH of the water used in the oxide forming process. Doing this makes it possible to adjust the surface so that the following process can advance in an ideal way. For example, adjusting the pH to the acidic side (pH < 7) makes it possible for metal atoms that are weakly bound to the surface to be removed by dissolution in the water.

Oxide thin film is formed on the substrate by performing the above processes one time (adsorption or deposition → oxidation) or by repeating them a plurality of times (adsorption or deposition → oxidation → adsorption or deposition → oxidation →...).

In the present invention, as the oxide forming starting material, there can be used two or more types of starting material comprised of different elements subjected to oxidation. For example, in the case of formation of oxide thin film containing two or more types of elements, such as metal silicate, in the process of adsorbing or depositing the starting material on the substrate, two or more types of starting material comprised of different elements to be oxidized are used simultaneously to adsorb or deposit the two or more types of starting material on the substrate. This is followed in the oxide forming process by the contacting of water in the liquid state. Complex oxide thin film is formed on the substrate by doing this one time (adsorption or deposition → oxidation) or a plurality of times (adsorption or deposition → oxidation → adsorption or deposition → oxidation →...).

After one, two or more types of starting material have been used for adsorption or deposition on the substrate and oxide formation is effected one time or repeated a plurality of times, the working starting material can be changed and further adsorption or deposition performed to form on the substrate a thin film having a layered structure comprised of two or more types of oxide layer.

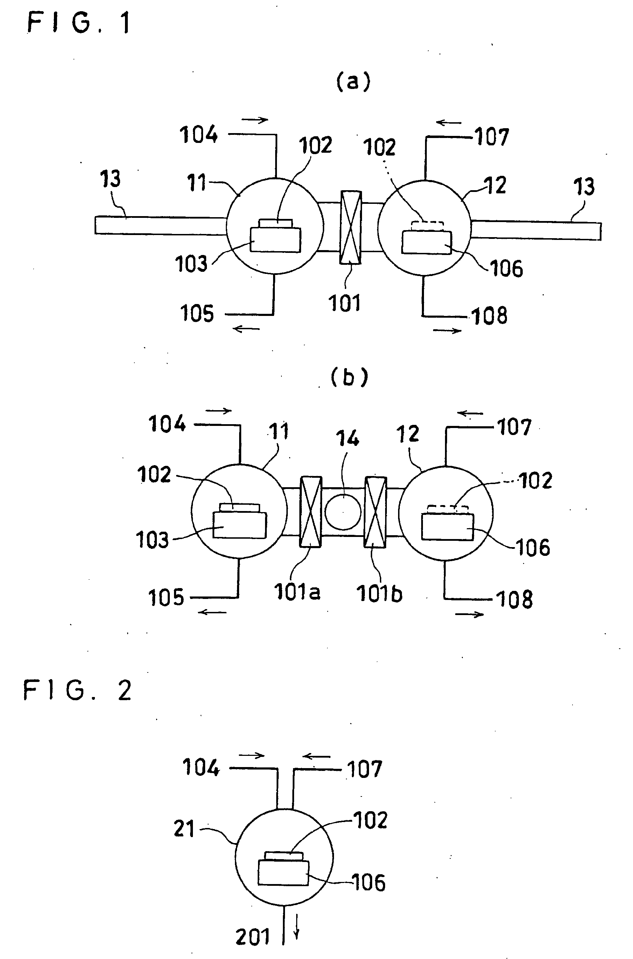

An apparatus for manufacturing the oxide thin film of the present invention will now be described with reference to Figures 1 and 2.

The manufacturing apparatus shown in Figures 1(a) and 1(b) comprises at least two chambers, which are a chamber (hereinafter referred to as the "adsorption chamber") 11 in which starting material is adsorbed or deposited on the substrate, and a separate chamber (hereinafter referred to as the "reaction chamber") 12 in which oxide forming starting material adsorbed or deposited on the substrate is contacted with water in a liquid state for starting material oxide formation.

The apparatus of Figure 1(a) is one in which the adsorption chamber 11 and the reaction chamber 12 are each provided with a substrate transport mechanism 13 in communication with both chambers. However, one of the chamber substrate transport mechanisms can be omitted. In the case of the manufacturing apparatus of Figure 1(b), an intermediate chamber 14 having a transport mechanism is located between the adsorption chamber 11 and the reaction chamber 12. In the case of both Figures 1(a) and 1(b), the chambers are separated by gate valves 101, 101a, 101b. The adsorption chamber 11 is provided with a stage 103 used for heating a housed substrate 102, if necessary, and a starting material supply mechanism 104. The starting material supply mechanism 104 can also be used to introduce inert gas. A purge type air exhaust mechanism 105 is included for performing adsorption or deposition under reduced. pressure and for purging starting material gases and solvents.

The reaction chamber 12 includes a mechanism 107 for introducing liquid-state water or water vapor, a stage 106 for cooling and heating the substrate, and a mechanism 108 for discharging water in liquid or vapor form. The discharge mechanism 108 can also be used when it is necessary to produce liquid-state water by adiabatic expansion of a gas containing water vapor. To promote the evaporation from the substrate of contacted liquid water, the stage 106 can be designed to be rotatable at high speed or the water introduction mechanism 107 to be connectable to an inert gas source for blowing inert gas onto the substrate surface.

Figure 2 shows a manufacturing apparatus in which adsorption or deposition of the starting material on the substrate and the oxidation thereof are performed in the same chamber.

In this manufacturing apparatus, the chamber 21 includes a stage 106 used for heating and cooling a substrate 102, a starting material supply mechanism 104 and a water supply mechanism 107. The starting material supply mechanism 104 and water supply mechanism 107 are the same as in the apparatus of Figures 1(a) and 1(b). The apparatus also includes a mechanism 201 for discharging from the chamber starting material used in the process of adsorbing or depositing starting material on the substrate, and water introduced in the subsequent oxidation process. This makes it possible to prevent reaction between the water and any starting material remaining anywhere inside the chamber except on the substrate surface, enabling reactions at location other than the substrate surface to be suppressed.

Moreover, although in the manufacturing apparatuses of Figures 1(a), 1(b) and 2 the starting material supply mechanism 104 or water supply mechanism 107 is also used as an inert gas introduction mechanism, and the discharge mechanisms 108 and 201 are also used as vacuum suction mechanisms for adiabatic expansion of gas containing water vapor, these inert gas introduction or suction mechanisms may be provided separately from the starting material supply mechanism, water supply mechanism and discharge mechanism.

Next, with respect to the manufacturing apparatuses illustrated in the drawings, examples of the manufacture of oxide thin film on the substrate surface are described in further detail in the following.

When the manufacturing apparatus of Figure 1 (a) is used, a substrate 102 having an oxidized, nitrided, hydrogenated or hydroxylated surface is mounted on the stage 103 in the chamber 11 by opening an opening/closing mechanism (not shown). Next, the opening/closing mechanism and gate valve 101 are closed to seal the adsorption chamber 11, after which the stage 103 is used to heat the substrate surface to a predetermined temperature and the starting material supply mechanism 104 is used to supply the oxidation starting material into the adsorption chamber 11 until a predetermined pressure is reached, to adsorb/deposit the oxide forming starting material on the surface of the substrate 102. After the deposition process is finished, the exhaust mechanism 105 is used to rid the adsorption chamber of the oxide forming starting material other than that on the surface of the substrate 102.

Next, the gate valve 101 is opened and the substrate transport mechanism 13 is used to transport the substrate 102 onto the stage 106 in the reaction chamber 12, after which the gate valve 101 is closed, sealing the reaction chamber 12. Then, using the stage 106, the substrate 102 is heated to a predetermined temperature while the water introduction mechanism 107 is used to introduce water into the reaction chamber 12 to transform the starting material adsorbed or deposited on the substrate surface into oxide. The water discharge mechanism 108 is used to discharge water inside the reaction chamber, at which time, if required, the stage 106 is heated and/or the flow channel can be switched from the water introduction mechanism 107 to blow inert gas to speed up the elimination of moisture.

When oxide thin film formation processing of the substrate 102 is performed one time, the opening/closing mechanism (not shown) provided on the reaction chamber 12 is opened and the substrate on which the oxide thin film has been formed is removed from the reaction chamber 12.

When the oxide thin film formation processing is performed a plurality of times, without removing the substrate on which the oxide thin film has been formed, the gate valve 101 is opened and the substrate transport mechanism 13 is used to again transport the substrate on the surface of which the oxide thin film has been formed to the stage 103 in the adsorption chamber where the adsorption/deposition process is performed. After this process is finished, the transport mechanism 13 is used to move the substrate into the reaction chamber 12 where the oxide forming process takes place. This operation is repeated as required.

The above apparatus operation has been described with reference to a case in which both the adsorption chamber 11 and the reaction chamber 12 are provided with an opening/closing mechanism. However, it is possible to effect substrate introduction and removal using a single opening/closing mechanism provided on either the adsorption chamber 11 or the reaction chamber 12. If this opening/closing mechanism is provided on the adsorption chamber 11, the opening/closing mechanism is opened to mount the substrate on the stage 103 in the adsorption chamber 11 to perform the process of adsorption or deposition in the adsorption chamber 11, after which the substrate is transported to the reaction chamber and the oxide forming process is performed. After the oxide forming process is finished, the transport mechanism is used to move the substrate to the adsorption chamber 11, and the opening/closing mechanism is opened for substrate removal. When only the reaction chamber 12 is provided with an opening/closing mechanism, the opening/closing mechanism is opened and the substrate mounted on the stage 106 in the reaction chamber 12, after which the transport mechanism provided in the intermediate chamber 14 is used to move the substrate to the stage 103 of the adsorption chamber 11, where the adsorption/deposition process is performed. The substrate is then moved to the reaction chamber 12 and the oxide forming process performed. After the oxide forming process is finished, the opening/closing mechanism of the reaction chamber 12 is opened and the substrate removed. When both of the chambers are provided with an opening/closing mechanism, the opening/closing mechanism of the adsorption chamber 11 is opened to introduce the substrate, and after completion of the prescribed process the opening/closing mechanism of the reaction chamber 12 is opened and the substrate is removed.

When the manufacturing apparatus of Figure 1(b) is used, the opening/closing mechanism (not shown) of the intermediate chamber 14 is left open and the substrate 102 surface-treated as in the above case, as required, is inserted into the intermediate chamber, the gate valve 101a is opened and the transport mechanism provided in the intermediate chamber is used to transport the substrate 102 onto the stage 103 in the adsorption chamber 11. The gate valve 101a is then closed and, as in the above case, oxide forming starting material is adsorbed or deposited on the substrate. After the completion of this process, the gate valves 101a and 101b are opened and the transport mechanism provided in the intermediate chamber 14 is used to move the substrate 102 in the adsorption chamber 11 to the stage 106 in the reaction chamber 12, via the intermediate chamber 14. The gate valve 101b is then closed and, as in the above case, water in the liquid state is contacted with the substrate 102 to perform the oxide forming process. After the completion of this process, in cases where the oxide thin film formation processing is performed one time, the gate valve 101b is opened and the transport mechanism used to transport the substrate 102 on which the oxide thin film has been formed, from the reaction chamber 12 to the intermediate chamber 14. The opening/closing mechanism of the intermediate chamber 14 is left open and the substrate 102 is removed. However, when the oxide thin film formation processing is performed a plurality of times, without taking out the substrate on which the oxide thin film has been formed, the gate valves 101b and 101a are opened and the substrate transport mechanism provided in the intermediate chamber 14 is used to transport the substrate from the reaction chamber 102 onto the stage 103 in the adsorption chamber 11. This operation is repeated as required.

The above manufacturing apparatus operation has been described with reference to using the opening/closing mechanism of the intermediate chamber 14 for substrate introduction and removal. However, provision of the intermediate chamber 14 opening/closing mechanism may be omitted and substrate introduction and removal effected using an opening/closing mechanism provided on one or both of the adsorption chamber 11 and reaction chamber 12. When only the adsorption chamber 11 is provided with an opening/closing mechanism, the opening/closing mechanism is opened and the substrate mounted on the stage 103 in the adsorption chamber 11 and the process of adsorption or deposition is performed. Then, the substrate is transported to the reaction chamber and the oxide forming process performed. After the oxide forming process is finished, the transport mechanism is used to move the substrate to the adsorption chamber 11, the opening/closing mechanism of the adsorption chamber 11 is opened and the substrate removed. When only the reaction chamber 12 is provided with an opening/closing mechanism, the opening/closing mechanism is opened and the substrate mounted on the stage 106 in the reaction chamber 12, after which the transport mechanism provided in the intermediate chamber 14 is used to move the substrate to the stage 103 of the adsorption chamber 11, where the adsorption/deposition process is performed. The substrate is then moved to the reaction chamber 12 and the oxide forming process performed. After the oxide forming process is finished, the opening/closing mechanism of the reaction chamber 12 is opened and the substrate removed.

When the manufacturing apparatus of Figure 2 is used, the opening/closing mechanism (not shown) provided on the chamber 21 is opened and the substrate surface-treated as in the above case, as required, is placed on the stage 106 that can be heated and cooled. The stage 103 is used to heat the substrate surface to a predetermined temperature and the starting material supply mechanism 104 is used to supply the oxidation starting material into the chamber 21 until a predetermined pressure is reached, to adsorb or deposit oxide forming starting material on the surface of the substrate 102. After the adsorption/deposition process is finished, the exhaust mechanism 201 is used to rid the chamber 21 of oxide forming starting material other than that on the surface of the substrate 102.

Next, using the stage 106, the substrate 102 is controlled to a predetermined temperature while the water introduction mechanism 107 is used to introduce water into the chamber 21 to form oxide on the substrate surface. Then, the water discharge mechanism 201 is used to remove the water inside the chamber, at which time, if required, the stage 106 is heated and/or the flow channel can be switched from the water introduction mechanism 107 to blow inert gas to speed up the elimination of moisture.

When oxide thin film formation processing of the substrate 102 is performed one time, after the oxide forming process is finished the chamber 21 is left open and the substrate on which the oxide thin film has been formed is removed. When the oxide thin film formation processing is performed a plurality of times, the adsorption/deposition process and oxide forming process are repeated.

The substrate transport mechanism 13 of the manufacturing apparatus shown in Figure 1(a) has at its tip a means to operate from outside the chamber a carrier bar on which a substrate can be mounted. Specific examples include a mechanism that uses magnetic attraction to move the carrier bar in the transport mechanism, comprising two materials that are mutually attracted by a magnetic force, the carrier bar having one of the materials and a moving member the other, with the moving member being operated outside the apparatus to be slidable along a transport path, or a mechanism for moving the carrier bar provided with an electric motor, a rack and pinion for converting the motor rotation into linear motion, and a carrier bar with a screw means or the like housed in the apparatus, with the amount of motor rotation being externally controlled. In the case of the latter, the electric motor can be provided externally with just the rotation shaft sealably extending into the apparatus.

The substrate transport mechanism of Figure 1(b) is provided with an intermediate chamber 14 and an extendible magic hand that can grip and release a substrate and can be externally operated. This can be a general-purpose arrangement in a clustered semiconductor apparatus.

Next, a working example of the present invention is described. The invention is not limited to the following embodiment.

### Working Example:

For the substrate, a hydrogen-terminated Si wafer was used that was etched in a solution (1%) of hydrofluoric acid, ozone-oxidized at room temperature, and had an approximately 0.5 nm oxide surface film. The substrate was placed in the adsorption chamber 11 of the manufacturing apparatus shown in Figure 1(a), which was evacuated to 10 to 6 Pa using a turbo molecular pump. A valve provided between the chamber and the turbo molecular pump was then closed and SiCl₄ was introduced into the chamber at a substrate temperature of 220°C until the pressure reached 1.33 kPa to adsorb SiCl₄ on the substrate surface.

After the adsorption operation was finished, the chamber was rid of remaining SiCl₄ groups and inert gas was introduced and the pressure returned to atmospheric pressure. Next, gate valve 101 was opened, the substrate was transported to the reaction chamber 12 which was then sealed shut and the substrate was contacted with the ultrapure water having a specific resistance of 18.3 MΩcm for 1 second (room temperature) to form SiO₂ thin film on the substrate surface. Nitrogen gas was then blown for drying, concluding the oxide forming process.

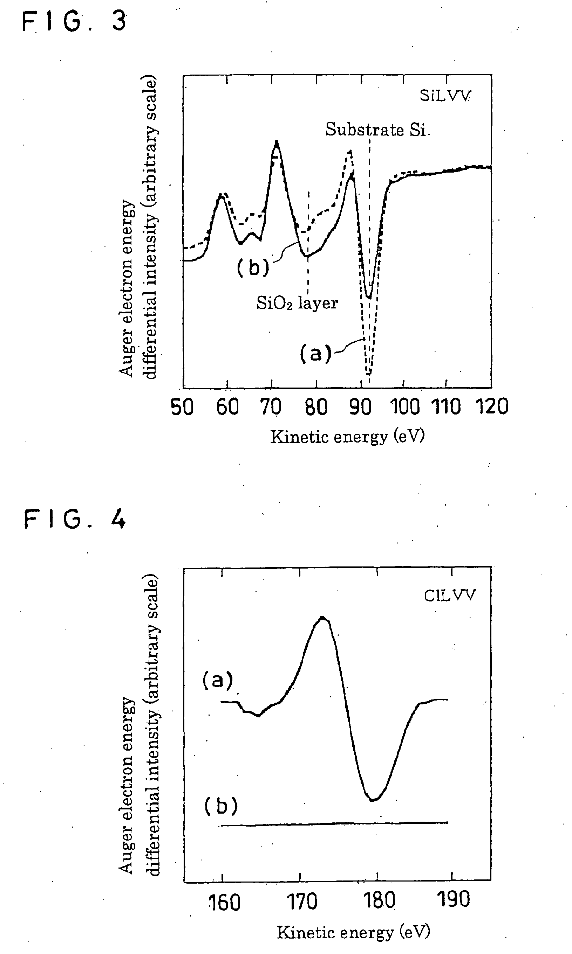

Figure 3 shows the Auger electron spectrogram of the substrate subjected to four cycles of the adsorption process and oxide forming process.

In the Si LVV Auger spectrogram shown in Figure 3, the 92 eV negative peak is that of the substrate Si and the 76 eV negative peak is that of the SiO₂ layer. The dotted line (a) in Figure 3 is the measurement taken in respect of the ozone-oxidized substrate before growing the SiO₂ thin film, and the solid line (b) denotes the measurement taken after four cycles of the adsorption process and oxidation process. In the case of b, the 76eV SiO₂ peak is large and the 92eV substrate silicon peak is small. This shows that SiO₂ growth is occurring.

Assuming an Auger electron escape depth of 0.6 nm, the estimated thickness of the SiO₂ film was 0.5 nm on the ozone-oxidized substrate and 0.9 nm after four cycles. That is, the SiO₂ grows approximately 0.1 nm per cycle of adsorption process and oxide forming process.

Figure 4 shows the results of measurement of the Cl LVV Auger electron energy region. Curve (a) in Figure 4 shows the measurement taken after one SiCl₄ adsorption process on the ozone-oxidized silicon substrate. The C1 LVV Auger electron signal can be clearly observed, showing that SiCl₄ adsorption is actually occurring. The straight line (b) of Figure 4 denotes the measurement taken after four cycles of the adsorption process and oxide forming process. No Cl is detected, showing that due to the oxide forming process, Cl is reduced to or below the Auger electron spectrograph sensitivity (0.1% to around 1%).

### Industrial Applicability:

This invention utilizes the atomic precision control and uniform, large-area film growth that are the advantages of the ALD method while making it possible to manufacture oxide thin film having a very low concentration of impurities. In particular, the invention provides an extremely useful means of obtaining outstanding gate insulation film that is indispensable for improving the performance of MOS transistors.

## Claims

1. A method of manufacturing oxide thin film by a process of adsorbing or depositing oxide forming starting material on a substrate followed by an oxide forming reaction process, **characterized in that** the oxide forming reaction process is performed using water in a liquid state.

2. The manufacturing method according to claim 1, **characterized in that** the process of adsorbing or depositing oxide forming starting material on a substrate and oxide forming reaction process are performed one time or a plurality of times.

3. The manufacturing method according to claim 1 or 2, **characterized in that** the oxide forming starting material comprises two or more different types of oxide subject elements.

4. The manufacturing method according to claim 3, **characterized in that** the process of adsorbing or depositing oxide forming starting material on a substrate also includes simultaneous use of two or more different types of subject oxide elements, or differentiating the oxide forming starting material after performing the adsorbing or depositing process and oxidation process one time or a plurality of times.

5. A manufacturing apparatus that implements the manufacturing method according to any one of claims 1 to 4, **characterized in that** it is equipped with separate chambers to perform, respectively, the process of adsorbing or depositing oxide forming starting material on a substrate and the oxide forming process utilizing contact with water in a liquid state.

6. A manufacturing apparatus that implements the manufacturing method according to any one of claims 1 to 4, **characterized in that** it is equipped with a single chamber to sequentially perform the process of adsorbing or depositing oxide forming starting material on a substrate and the oxide forming reaction process utilizing contact with water in a liquid state.
